Europäisches Patentamt

European Patent Office

Office européen des brevets

(19)

(11) Numéro de publication: **0 011 013.**
**B1**

(12) **FASCICULE DE BREVET EUROPEEN**

(45) Date de publication du fascicule du brevet: **03.03.82**

(21) Numéro de dépôt: **79400759.1**

(22) Date de dépôt: **17.10.79**

(51) Int. Cl.³: **H 01 L 21/48,**
**H 01 L 23/12,**
**H 01 L 23/14, H 01 L 23/48**

(54) **Procédé de fabrication de dispositifs comportant des bossages métalliques calibrés et dispositifs d'écriture électrocatalytique ainsi réalisés.**

(30) Priorité: **03.11.78 FR 7831121**

(43) Date de publication de la demande:
**14.05.80 Bulletin 80/10**

(45) Mention de la délivrance du brevet:
**03.03.82 Bulletin 82/9**

(84) Etats contractants désignés:
**CH DE GB**

(56) Documents cités:
**néant**

**US - A - 3 838 984**

**IBM TECHNICAL DISCLOSURE BULLETIN, vol. 20. no. 8, janvier 1978, New York, US, E. BERNDLMAIER et al.: "High performance package", pages 3090—3091.**

(73) Titulaire: **THOMSON-CSF**
**173, Boulevard Haussmann**
**F-75360 Paris Cedex 08 (FR)**

(72) Inventeur: **Val, Christian**
**"THOMSON-CSF" - SCPI 173, bld Haussmann**
**F-75360 Paris Cedex 08 (FR)**

(74) Mandataire: **Desperrier, Jean-Louis et al,**
**Thomson-CSF SCPI 173, Bld Haussmann**
**F-75360 Paris Cedex 08 (FR)**

Courier Press, Leamington Spa, England.

Procédé de fabrication de dispositifs comportant des bossages métalliques calibrés et dispositifs d'écriture électrocatalytique ainsi réalisés

L'invention se rapporte au domaine des circuits sur films-supports et a plus particulièrement pour objet un procédé de réalisation de bossages calibrés, en surépaisseur par rapport aux films sur lesquels ils sont formés.

La réalisation industrielle de bossages métalliques calibrés, sur des films supports plastiques sur lesquels peuvent être rapportés des circuits intégrés et sur lesquels peuvent être formés les conducteurs d'alimentation et de sortie de ces circuits, pose des problèmes technologiques importants.

En effet, lorsque des bossages métalliques sont réalisés, par exemple en Argent, sur des épaisseurs de l'ordre de 100 à 200 $\mu$m, par recharge électrochimique, des contraintes se développent dans ces bossages et rendent les contacts fragiles. Un procédé de realisation de bossages par depôt electrochimique et par exemple décrit dans US - A - 3838984. Des procédés tels que la découpe mécanique d'une grille sur laquelle les bossages sont rapportés ou le découpe mécanique d'un matériau colaminé sont coûteux et de plus ne permettent pas d'obtenir des bossages en ligne avec un pas de l'ordre du millimètre.

L'invention a pour objet un procédé de fabrication de bossages métalliques calibrés sur un film support ne présentant pas les inconvénients des procédés sus-mentionnés et permettant en particulier de réaliser industriellement des bossages en ligne faiblement espacés, d'épaisseur constante et de faible coût. Le procédé consiste à faire des fenêtres dans le film support plastique, à coller sur ce film plastique un film métallique sur lequel peuvent être photogravés des conducteurs, à déposer sur le film métallique affleurant au fond des alvéoles un matériau de soudure, puis à souder dans les alvéoles des billes métalliques calibrées obtenues industriellement avec une bonne précision.

L'invention sera mieux comprise et d'autres caractéristiques apparaitront à l'aide de la description qui suit en référence aux figures annexées:

La figure 1 représente, en coupe, un film support muni d'un bossage calibré obtenu par le procédé suivant l'invention;

La figure 2 représente, en plan, le film support portant les bossages calibrés;

La figure 3 représente, en plan, la face du support opposée à celle portant les bossages sur laquelle est rapporté un circuit intégré avec ses conducteurs d'alimentation et ses conducteurs de sortie.

Le montage des circuits intégrés sur film perforé support par un procédé du type T.A.B. (transfert automatique sur bande) permet de réaliser automatiquement les soudures des pattes du circuit intégré sur le film souple support. Ce montage facilite les opérations de test qui peuvent être effectuées de manière automatique ou semi-automatique et le montage de tels circuits intégrés sur circuits imprimés. Il est possible de tirer parti au mieux du film support en prévoyant sur la face de ce film opposée à la face portant le circuit intégré des bossages métalliques en contact, à travers des fenêtres percées dans le film support, avec les bandes conductrices soudées aux pattes de sortie du circuit intégré. Ces bossages métalliques peuvent être utilisés directement comme contacts avec des conducteurs situés dans un autre plan ou comme pointes de contact sur un papier spécial à imprimer, les contacts initiant, lorsqu'ils sont alimentés, une réaction électrocatalytique et agissant comme catalyseur.

Le procédé de réalisation de bossages sur un support, suivant l'invention, permet de réaliser des contacts très fiables, positionnés avec une grande précision qui peuvent être faiblement espacés et ont une épaisseur constante.

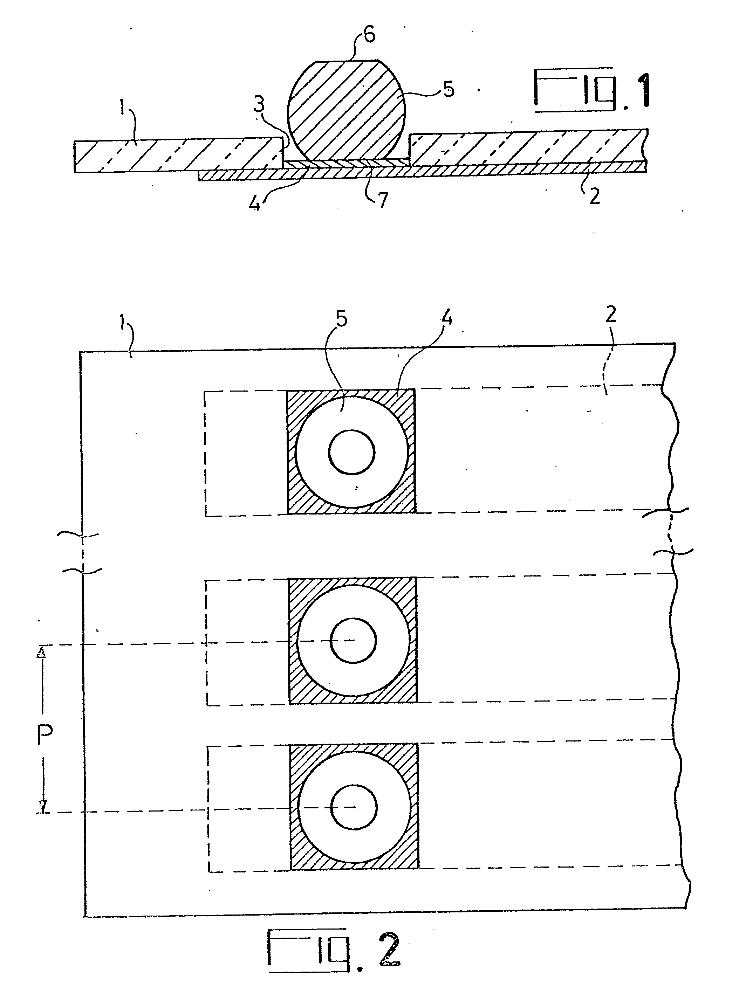

La figure 1 représente schématiquement en coupe un bossage sur film support obtenu par le procédé suivant l'invention et la figure 2 est une vue en plan de ce même film support. Le film 1 est un film souple, isolant. Les bossages sont obtenus de la manière suivante: le film souple 1 est percé suivant un motif correspondant à la répartition des bossages à obtenir par matriçage ou par photogravure. Le film souple est généralement un film de polyester ou de polyimide. Les deux techniques pour former les fenêtres 3 (matriçage en photogravure) permettent d'avoir des fenêtres alignées faiblement espacées (espacement de l'ordre du millimètre) avec une très grande précision. Le film plastique percé de ces fenêtres est ensuite recouvert, sur l'une de ses faces, d'un film de cuivre 2. Pour cela le film plastique peut avoir été, au préalable, recouvert d'une colle polymère, elle-même recouverte d'un film protecteur. Les fenêtres 3 sont alors formées, puis le film protecteur est enlevé et le film de cuivre 2 est collé au moyen de la colle polymère sur le film support 1. Ce film de cuivre 2 peut alors être photogravé pour former des conducteurs séparés, chacun affleurant au niveau d'une fenêtre.

L'étape suivante du procédé de fabrication consiste alors à déposer sur le cuivre qui affleure au fond des alvéoles ainsi formées un matériau de soudure 4, par exemple de l'étain ou un mélange d'étain et de plomb. Ce revêtement peut être effectué par un procédé chimique, ou électrochimique, le film de cuivre agissant comme conducteur et le film plastique comme épargne, ou par un procédé mécanique, par exemple par étamage au trempé, à la vague ou par dépôt d'une pâte à souder. L'épaisseur du matériau de soudure à déposer est déterminée pour obtenir, lorsque les billes seront soudées dans les alvéoles, un soudage résistant mécaniquement aux sollicitations appliquées sur les bossages. De plus, il faut tenir compte de cette épaisseur de soudure lors du choix des billes à placer dans les alvéoles de façon que le bossage ait une épaisseur totale correspondant à celle nécessaire pour l'application envisagée.

L'étape suivante du procédé de fabrication des bossages est la mise en place des billes 5 dans les alvéoles. Les billes sont obtenues industriellement très aisément. Elles peuvent être calibrées très précisément, la tolérance pouvant être de 5 $\mu$m sur un diamètre de l'ordre de 100 à 200 $\mu$m. Le matériau constituant les billes est choisi en fonction de l'application envisagée. Pour une application en télécopie utilisant un procédé d'impression du type électrocatalytique, les bossages sont destinés à initier la réaction électrocatalytique et sont utilisés pour apporter le catalyseur. Dans une telle application les billes sont des billes d'argent et sont consommées au fil des impressions, ce qui implique qu'elles aient une épaisseur suffisante.

Pour le placement des billes dans les alvéoles, plusieurs procédés peuvent être utilisés. Tout d'abord les billes peuvent être déposées directement dans les alvéoles par exemple au moyen d'un bol vibrant qui les fera tomber dans les alvéoles. Les billes peuvent également être placées dans un support comportant des alvéoles ou des V de centrage. Le film support avec ses alvéoles est alors placé au-dessus du support portant les billes, les alvéoles du film support étant placées au-dessus des billes. L'ensemble est alors retourné de façon que les billes se placent dans les alvéoles du film support. L'ensemble est alors prêt pour le soudage. Pour que la zone de soudage de la bille et la zone de la bille diamétralement opposée à la zone de soudage et destinée à faire contact avec le papier à imprimer ou avec un conducteur, aient des dimensions suffisantes, l'ensemble peut être pressé pour former des méplats 6 et 7. Ce pressage peut également servir à corriger des défauts d'épaisseur du matériau de soudure ou de la bille de façon que toutes les zones des billes destinées aux contacts soient coplanaires. Le soudage au four peut alors être effectué. Ce soudage est fait en continu ou en discontinu dans un four à atmosphère légèrement réductrice. Un film support en polyester ne résiste qu'à des températures de soudage inférieures à 140°C. Par contre, un film support en polyimide résiste aux températures de soudage couramment utilisées, de l'ordre de 260°C. Le film support est donc choisi en fonction du matériau constituant les billes, du matériau de soudure utilisé et donc de la température de soudage.

La figure 2 montre en vue de dessus le film support muni de bossages obtenus par le procédé décrit ci-dessus. Les mêmes éléments que sur la figure 1 ont été désignés par les mêmes repères. Le pas p entre les billes peut sans inconvénient être de l'ordre du millimètre ou même inférieur.

Dans le but de réduire le nombre de connexions à effectuer, les circuits de commande peuvent être montés sur le même film support que celui sur lequel sont réalisés les bossages.

Le procédé de fabrication des bossages peut être mis en oeuvre parallèlement au procédé de montage des circuits intégrés sur le film souple, certaines étapes de la fabrication des bossages nécessitant les mêmes opérations que le montage des circuits intégrés sur film souple par des procédés du type T.A.B. (transfert automatique sur bande). En particulier l'estampage du film support pour former les fenêtres dans lesquelles sont logées les billes peut être effectué en même temps que l'estampage pour former les trous d'indexation du film, les fenêtres destinées à recevoir les circuits intégrés, et les fenêtres permettant de souder les conducteurs métalliques d'alimentation du circuit intégré aux conducteurs d'alimentation qui sont formés sur la face du film opposée à la face destinée à porter le circuit intégré.

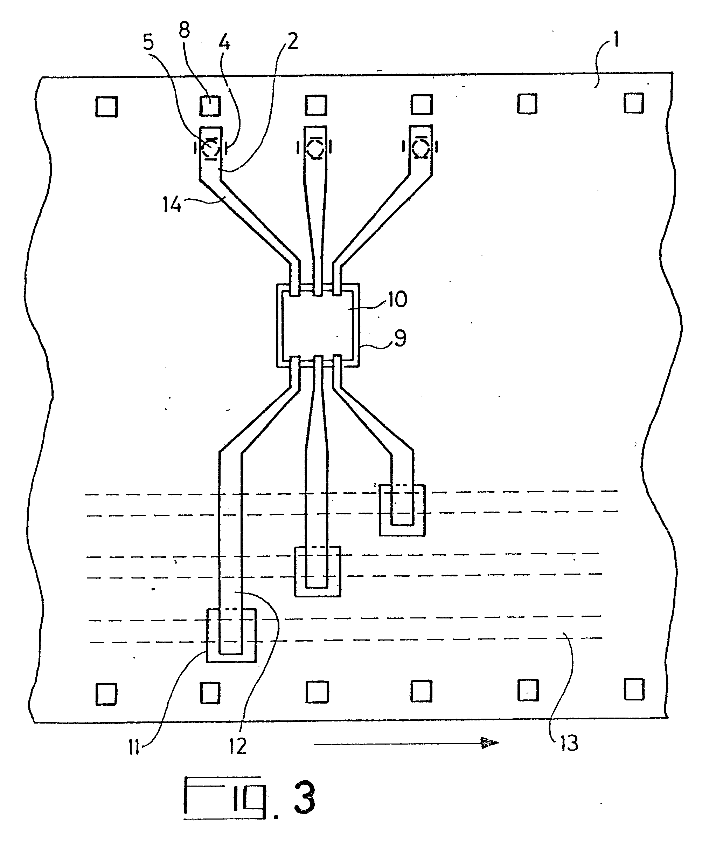

La figure 3 représente une bande de film support sur lequel a été monté un circuit intégré et sur lequel ont été réalisés des bossages selon l'invention. Le film 1 comporte des trous d'indexation tels que 8, une fenêtre 9 dans laquelle est placé le circuit intégré 10, des fenêtres telles que 11 permettant de souder les conducteurs d'alimentation du circuit intégré, tels que 12, aux conducteurs d'alimentation, 13, portés par l'autre face et représentés en pointillés sur la figure, et des alvéoles 3 représentées en pointillés dans lesquelles sont logées les billes 5 représentées également en pointillés. Chaque alvéole correspond à un conducteur de sortie 14 du circuit intégré. Les conducteurs 12 et 14 sont photogravés sur le film de cuivre collé sur le film support plastique. Les conducteurs d'alimentation 13 peuvent être photogravés sur un film de cuivre collé sur l'autre face du film plastique ou être photogravés sur un support souple ou rigide qui est ensuite rapporté sur l'autre face du film plastique. Le soudage des billes sur les conducteurs 14 et le soudage des conducteurs 12 aux conducteurs 13 peuvent être effectués simultanément.

Les bossages calibrés obtenus alimentés convenablement via un circuit intégré rapporté sur le même support sont directement utilisables. Par exemple, pour une application à l'impression électrocatalytique, un film plastique de longueur égale à la largeur du papier à impressionner peut être utilisé. Des bossages sont répartis sur cette longueur. A titre d'exemple, pour un papier de 216 mm de largeur, 108 bossages espacés de 2 mm peuvent être formés. Le film est avancé dans le sens de la largeur du papier 16 fois, de 1/8 mm à chaque pas: chaque bossage est donc utilisé 16 fois avant qu'une ligne complète soit impressionnée. La largeur des points nécessaire, de l'ordre de 60 μm peut être obtenue avec des billes de 200 μm de diamètre sur lesquelles des méplats sont formés. Le circuit intégré fournit des signaux obtenus à partir de l'analyse d'une ligne en 1728 points multiplexés en 16 fois 108 points.

L'invention n'est pas limitée à l'application envisagée ci-dessus. En particulier, il est possible d'utiliser des bossages ainsi formés sur un film support pour établir des contacts électriques entre les conducteurs portés par le film support en contact avec les bossages et d'autres conducteurs répartis par exemple sur un autre film support amené au-dessus du premier.

**Revendications**

1. Procédé de fabrication de dispositifs comportant des bossages métalliques calibrés (5) sur un film-support (1), le dit procédé étant caractérisé en ce qu'il consiste à ouvrir dans un film plastique (1) des fenêtres (3) de dimensions prédéterminées dans les zones où doivent être situées les bossages, à coller sur l'une des faces du film-support (1) un film métallique (2), à déposer sur les zones du film métallique obturant les dites fenêtres un matériau de soudure (4), puis à loger dans les dites fenêtres des billes calibrées (5) faites d'un métal malléable, ces billes dépassant l'autre face du film-support afin de former les dits bossages, calibrés à porter ensuite l'ensemble à la température de soudure afin de fixer les billes au film conducteur par le matériau de soudure, et, après soudage, à comprimer à froid 1' ensemble entre deux plateaux rigides pour obtenir, par déformation plastique, des méplats coplanaires aux sommets des billes.

2. Dispositif d'écriture électrocatalytique comportant une rangée de bossages métalliques calibrés en matériau catalyseur, obtenu par le procédé de fabrication selon la revendication 1, caractérisé en ce que les dits bossage métalliques calibrés formant des éléments inscripteurs sont reliés à des circuits électriques de commande par des connexions plates gravées dans le dit film métallique.

**Claims**

1. A process of manufacturing devices comprising calibrated metallic bosses (5) on a carrier foil (1), characterized in that it comprises the steps of forming, in a plastic foil (1), windows (3) having predetermined dimensions, in the zones in which said bosses are to be located, gluing onto one of the surfaces of the carrier foil (1) a metallic foil (2), depositing a welding material (4) in that zones of said metallic foil which seal said windows, then placing into said windows calibrated balls (5) made of a deformable metal, said balls protruding from the other surface of the carrier foil so as to form said calibrated bosses, then heating the assembly to the welding temperature for fixing the balls on the conducting foil by means of the welding material, and, after welding, pressing at low temperature the assembly between two rigid plates for shaping by plastic deformation coplanar flattened portions at the apices of said balls.

2. An electrocatalytic writing device comprising a row of calibrated metallic bosses made of a catalytic material and obtained by the manufacturing process according to claim 1, characterized in that said calibrated metallic bosses, which constitute writing organs, are connected to electrical control circuits by flat connections engraved in said metallic foil.

**Patentansprüche**

1. Verfahren zur Herstellung von Vorrichtungen mit kalibrierten metallischen Höckern (5) auf einer Trägerfolie (1), dadurch gekennzeichnet, dass man in einer Plastikfolie (1) in den Bereichen, in welchen die Höcker liegen sollen, Auslassungen (3) mit vorbestimmten Abmessungen schafft, dass man auf eine der Oberflächen der Trägerfolie (1) eine metallische Folie (2) aufklebt, dass man auf die die genannten Auslassungen verschliessenden Bereiche der metallischen Folie ein Schweissmaterial (4) aufbringt und sodann aus einem verformbaren Metall bestehende, kalibrierte Kugeln (5) in die Auslassungen einsetzt, wobei die Kugeln die andere Oberfläche der Trägerfolie überragen, um die genannten kalibrierten Höcker zu bilden, dass man hiernach die gesamte Baueinheit auf die Schweisstemperatur erhitzt, um die Kugeln vermittels des Schweissmaterials an der Leitfolie zu befestigen, und dass man nach dem Schweissen die Baueinheit bei niedriger Temperatur zwischen zwei steifen Platten presst, um durch plastische Verformung in einer gemeinsamen Ebene liegende Abflachungen an den Scheiteln der Kugeln zu erzeugen.

2. Elektrokatalytische Schreibvorrichtung mit einer Reihe von vermittels des Verfahrens nach Anspruch 1, hergestellten kalibrierten metallischen Höckern aus katalytischem Material, dadurch gekennzeichnet, dass die kalibrierten metallischen Höcker, welche Schreiborgane bilden, vermittels flacher, in der metallischen Folie gravierter Verbindungsleitungen an Steuerstromkreise angeschlossen sind.

Fig. 1

Fig. 2

Fig. 3